# FASCICULE DE BREVET EUROPEEN

(11) **EP 1 978 489 B1**
(45) Date de publication et mention de la délivrance du brevet: **22.12.2010**
(21) Numéro de dépôt: 08153821.7
(22) Date de dépôt: 31.03.2008
(51) Int. Cl.: G07B 17/00, H05K 5/00

(54) **Boîtier de machine de traitement de courrier à plaque d'identification détachable**
Gehäuse einer Maschine zur Postbearbeitung mit abnehmbarem Typenschild
Case of a mail processing machine with removable identification tag

(30) Priorité: 05.04.2007 FR 0754289
(43) Date de publication de la demande: 08.10.2008
(73) Titulaire: NEOPOST TECHNOLOGIES, 92220 Bagneux (FR)
(72) Inventeur: Claris Yannick N., 75016 Paris (FR)
(74) Mandataire: David, Alain

(56) Documents cités:
- FR-A- 2 877 472
- FR-A1- 2 764 422
- US-A1- 2004 003 256

## Description

### Domaine de l'invention

La présente invention se rapporte au domaine de l'identification des machines de traitement de courrier et elle concerne plus particulièrement un boîtier de machine de traitement de courrier dont la plaque d'identification est détachable pour éviter tout marché frauduleux de machines déclassées ou en fin de vie.

### Art antérieur

Aujourd'hui l'identification des machines de traitement de courrier est effectuée par la gravure d'un marquage, le collage d'une étiquette ou la pose par vis, rivetage ou clipage d'une plaque d'identification sur le boîtier de ces machines ainsi qu'il est décrit dans le document US 2004/003256. Or, lorsque ces machines arrivent en fin de vie ou sont déclassées pour des raisons réglementaires, il est nécessaire, pour éviter toute fraude, de leur retirer leurs identifiants et de signaler cet état de fait au concessionnaire de la machine ou à l'administration postale concernée. Cette déclassification des machines pose aujourd'hui de nombreux problèmes. En effet, lorsque l'identifiant est une gravure, celle-ci doit être effacée, les différents numéros d'identification et références qu'elle comporte ayant été préalablement noté pour les communiquer au concessionnaire. Ces opérations de relevé et de grattage sont coûteuses en temps et en main d'oeuvre. De même, lorsque l'identifiant est une étiquette collée, il est nécessaire de décoller celle-ci puis de nettoyer le boîtier à l'alcool. Le décollement de l'étiquette entraînant en général sa destruction, il est aussi obligatoire au préalable d'avoir noté les différents numéros d'identification et références qu'elle comporte pour les communiquer au concessionnaire. Le document FR 2877472 décrit un système dans lequel un élément unique fait fonction à la fois de scellé et d'identifiant. Ces opérations de relevé et de nettoyage sont coûteuses en temps et en main d'oeuvre. Enfin, lorsque l'identifiant est une plaque d'identification, le relevé n'est pas nécessaire la plaque étant retournée au concessionnaire mais il est nécessaire de recourir à un outillage particulier pour son démontage et il est créé des résidus, vis ou rivets par exemple, qui doivent être évacués.

### Objet et définition de l'invention

La présente invention a donc pour objet un boîtier de machine de traitement de courrier dont l'identifiant peut être retiré en fin de vie de la machine sans création de résidus polluants. Un but de l'invention est aussi d'effectuer ce retrait de façon simple et peu coûteuse en main d'oeuvre.

Ces buts sont atteints par un boîtier de machine de traitement de courrier comportant une plaque d'identification de la machine, caractérisé en ce que ladite plaque d'identification est formée par une partie dudit boîtier reliée à la partie restante dudit boîtier par une zone de fragilisation périphérique dont la rupture permet le détachement de ladite plaque d'identification.

Ainsi, avec cette configuration particulière, la plaque d'identification peut être détachée du boîtier très simplement sans création d'aucun résidu polluant et sans le recours à un outillage spécifique, la transmission de la plaque au concessionnaire permettant d'assurer l'indispensable historique de fin de vie.

Avantageusement, ladite zone de fragilisation comporte une pluralité de ponts de boîtier sécables manuellement, ces ponts étant en outre formés par des zones dudit boîtier de moindre épaisseur de façon à en faciliter la rupture.

De préférence, ladite plaque d'identification détachable est de forme rectangulaire et reliée à ladite partie restante dudit boîtier par au moins quatre ponts de boîtier.

De préférence, des identifiants de la machine sont gravés sur ladite plaque d'identification détachable ou portés sur une étiquette collée sur ladite plaque d'identification détachable. Avantageusement, ledit boîtier et ladite plaque d'identification détachable est en matière plastique.

L'invention concerne également toute machine de traitement de courrier comportant un tel boîtier.

### Brève description des dessins

Les caractéristiques et avantages de la présente invention ressortiront mieux de la description suivante, faite à titre indicatif et non limitatif, en regard des dessins annexés sur lesquels :
- la figure 1 est une vue en perspective d'une machine de traitement de courrier comportant un boîtier selon l'invention, et
- la figure 2 est une loupe d'un coté du boîtier de la figure 1.

### Description détaillée d'un mode de réalisation préférentiel

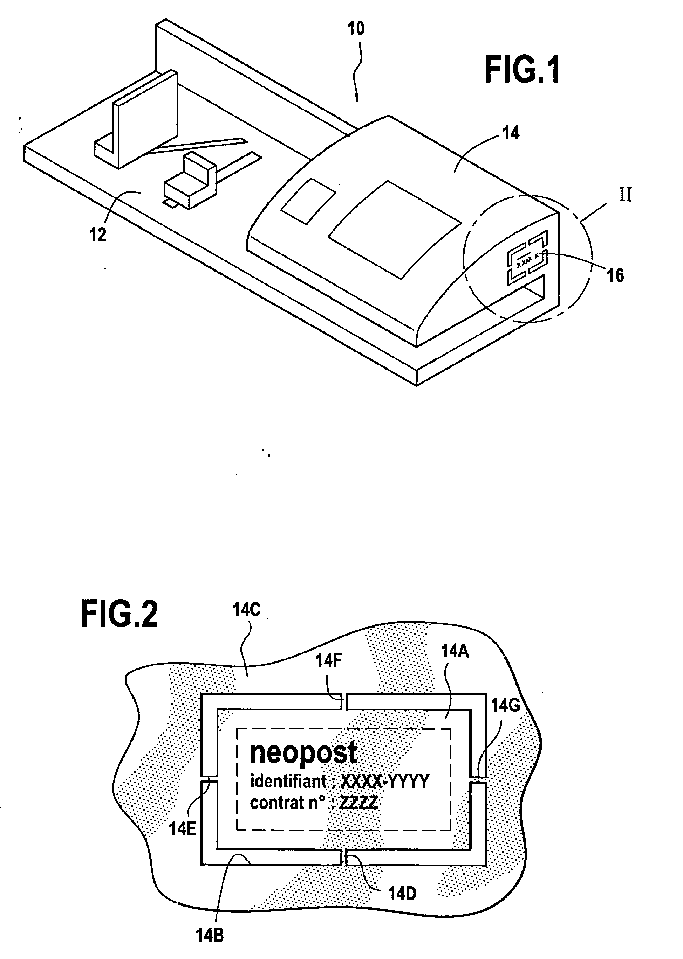

Une machine de traitement de courrier 10 est illustrée en perspective à la figure 1. Elle comporte classiquement, sans que cette énumération ne soit limitative, un module d'alimentation 12 pour stocker une pile d'articles de courrier à traiter suivi par un module effectuant la séparation un à un des articles de courrier et un module d'impression assurant l'affranchissement des articles de courrier ainsi séparés, ces deux derniers modules étant classiquement disposés dans un boîtier unique 14 comportant une plaque 16 d'identification de la machine. Cette plaque peut être disposée sur un coté du boîtier comme illustré, à l'arrière de celui-ci ou bien encore en dessous de la machine.

La figure 2 montre en détail cette plaque d'identification. Conformément à l'invention, elle est formée par une partie 14A du boîtier rectangulaire entourée d'une zone de fragilisation 14B sécable manuellement permettant son détachement du reste du boîtier 14C. De préférence, cette partie restante de boîtier est reliée à la plaque d'identification détachable par quatre ponts 14D, 14E, 14F, 14G. Ces ponts sont des parties sécables du boîtier constituées par des zones de ce boîtier de faible largeur et fragiles en épaisseur afin de permettre un détachement facile (de préférence manuellement) de la partie centrale 14A formant la plaque d'identification proprement dite lors de la rupture de ces ponts. Avantageusement, cette plaque comme l'ensemble du boîtier est fabriqué en un matériau plastique. On réduit ainsi les coûts et la masse de la machine.

Bien entendu, la forme de la plaque d'identification et le nombre de ponts assurant sa liaison avec la partie restante du boîtier ne sont aucunement limités à l'exemple illustré à la figure 2 et une forme polygonale ou circulaire avec une pluralité de ponts régulièrement répartis ou une simple zone de fragilisation de moindre épaisseur est naturellement envisageable.

Les identifiants tels qu'un numéro de série de machine et un numéro de contrat peuvent être gravés directement sur la partie centrale lors de la fabrication du boîtier ou bien portés sur une étiquette (dont les contours sont illustrés en traits pointillés) qui sera collée sur cette partie centrale également lors de la fabrication.

Lors de la mise hors circuit de la machine pour recyclage, la plaque d'identification sera détachée par un technicien du concessionnaire qui pourra donc l'intégrer dans son circuit logistique pour permettre au site de fabrication d'avoir une connaissance parfaite des machines en fin de vie. Le détachement facile de la plaque évite le recours à un outillage complexe et ne laisse aucun résidu polluant sur le site d'exploitation. Il est économe en temps et main d'oeuvre. On évite ainsi l'emploi d'inserts métalliques ou de pièces clipées fréquemment indémontables comme il est courant dans l'art antérieur.

## Revendications

1. Boîtier de machine de traitement de courrier comportant une plaque (16) d'identification de la machine, **caractérisé en ce que** ladite plaque d'identification est formée par une partie dudit boîtier (14A) reliée à la partie restante dudit boîtier (14C) par une zone de fragilisation périphérique (14B) comportant une pluralité de ponts de boîtier (14D, 14E, 14F, 14G) sécables manuellement et dont la rupture permet donc le détachement de ladite plaque d'identification.

2. Boîtier selon la revendication 1, **caractérisé en ce que** lesdits ponts sont en outre formés par des zones dudit boîtier de moindre épaisseur de façon à en faciliter la rupture.

3. Boîtier selon la revendication 1 ou la revendication 2, **caractérisé en ce que** ladite plaque d'identification détachable est de forme rectangulaire et reliée à ladite partie restante dudit boîtier par au moins quatre ponts de boîtier.

4. Boîtier selon la revendication 1, **caractérisé en ce que** des identifiants de la machine sont gravés sur ladite plaque d'identification détachable.

5. Boîtier selon la revendication 1, **caractérisé en ce que** des identifiants de la machine sont portés sur une étiquette collée sur ladite plaque d'identification détachable.

6. Boîtier selon l'une quelconque des revendications 1 à 5, **caractérisé en ce que** ledit boîtier (14) et ladite plaque d'identification détachable (14A) est en matière plastique.

7. Machine de traitement de courrier comportant un boîtier selon l'une quelconque des revendications 1 à 6.

## Claims

1. A mail processor machine casing having an identity plate (16) for identifying the machine, **characterized in that** said identity plate is formed by a portion (14A) of said casing that is connected to the remainder (14C) of said casing by a peripheral zone of weakness (14B) comprising a plurality of casing bridges (14D, 14E, 14F, 14G) that can be broken by hand and that, on being broken, makes it possible to detach said identity plate.

2. A casing according to claim 1, **characterized in that** said bridges are further formed by zones of said casing that are of smaller thickness so as to make them easier to break.

3. A casing according to claim 1 or 2, **characterized in that** said detachable identity plate is rectangular in shape and is connected to said remainder of said casing by at least four casing bridges.

4. A casing according to claim 1, **characterized in that** machine identifiers are etched onto said detachable identity plate.

5. A casing according to claim 1, **characterized in that** machine identifiers are carried on a label stuck to said detachable identity plate.

6. A casing according to any one of claims 1 to 5, **characterized in that** said casing and said detachable identity plate are made of a plastics material.

7. A mail processor machine having a casing according to claims 1 to 6.

## Patentansprüche

1. Gehäuse einer Postbearbeitungsmaschine umfassend ein Schild (16) zur Identifizierung der Maschine, **dadurch gekennzeichnet, daß** das Identifikationsschild von einem Teil des Gehäuses (14A) gebildet ist, der mit dem restlichen Teil des Gehäuses (14C) über einen zerbrechlichen Umfangsbereich (14B) verbunden ist, der eine Mehrzahl von Gehäusebrücken (14D, 14E, 14F, 14G) umfaßt, die manuell teilbar sind und deren Bruch die Abtrennung des Identifikationsschilds erlaubt.

2. Gehäuse nach Anspruch 1, **dadurch gekennzeichnet, daß** die Brücken zusätzlich von Bereichen des Gehäuses mit niedrigerer Dicke gebildet sind, um den Bruch zu vereinfachen.

3. Gehäuse nach Anspruch 1 oder Anspruch 2, **dadurch gekennzeichnet, daß** das Identifikationsschild viereckig ist und mit dem restlichen Bereich des Gehäuses über wenigstens vier Gehäusebrücken verbunden ist.

4. Gehäuse nach Anspruch 1, **dadurch gekennzeichnet, daß** Identifizierungen der Maschine auf dem Identifikationsschild eingraviert sind.

5. Gehäuse nach Anspruch 1, **dadurch gekennzeichnet, daß** Identifizierungen der Maschine auf einem auf dem entfernbaren Identifikationsschild aufgeklebten Etikett vorhanden sind.

6. Gehäuse nach einem der Ansprüche 1 - 5, **dadurch gekennzeichnet, daß** das Gehäuse (14) und das abtrennbare Identifikationsschild aus Kunststoff sind.

7. Postbearbeitungsmaschine mit einem Gehäuse nach einem der Ansprüche 1 bis 6.
